# EUROPEAN PATENT SPECIFICATION

(11) **EP 0 227 426 B1**
(45) Date of publication and mention of the grant of the patent: **23.03.1994**
(21) Application number: 86309843.0
(22) Date of filing: 17.12.1986
(51) Int. Cl.: H01S 3/101, H01S 3/25, H01S 3/19

(54) **Semiconductor laser**
Halbleiterlaser
Laser à semi-conducteur

(30) Priority: 20.12.1985 JP 285519/85
(43) Date of publication of application: 01.07.1987
(73) Proprietor: HITACHI, LTD., Chiyoda-ku, Tokyo 101 (JP)
(72) Inventor: Uomi, Kazuhisa, Hachioji-shi Tokyo (JP); Yoshizawa, Misuzu, Itabashi-ku Tokyo (JP); Ono, Yuichi, Nishitama-gun Tokyo (JP); Chinone, Naoki, Hachioji-shi Tokyo (JP); Kajimura, Takashi, Nishitama-gun Tokyo (JP)
(74) Representative: Calderbank, Thomas Roger

(56) References cited:
- EP-A- 0 174 839
- IEEE COMMUNICATIONS MAGAZINE, vol. 21, no. 6, September 1983, pages 20-27, IEEE, New York, US; Semiconductor Optoelectronic devices for free-space optical communications"
- OPTICS LETTERS, vol. 10, no. 4, April 1984, pages 125-127, Optical Society of America, New York, US; E. KAPON et al.: "Supermode analysis of phase-locked arrays of semiconductor lasers"
- IEEE JOURNAL OF QUANTUM ELECTRONICS, vol. QE-17, no. 5, May 1981, pages 718-722, IEEE, New York, US; K.A. SHORE et al.: "Near-field control in multistripe geometry injection lasers"
- APPLIED PHYSICS LETTERS, vol. 33, no. 8, 15th October 1978, pages 702-704, American Instiute of Physics, New York, US; D.R. SCIFRES et al.: "Beam scanning with twin-stripe injection lasers"
- APPLIED PHYSICS LETTERS, vol. 41, no. 11, December 1982, pages 1030-1032, American Institute of Physics, New York, US; D.R. SCIFRES et al.: "Continuous wave high-power, high-temperature semiconductor laser phase-locked arrays"

## Description

This invention relates to a semiconductor laser.

One example of a high output semiconductor laser is a phased-array semiconductor laser which has a large numbers of emission stripe regions, and which has optical coupling between the stripe regions. One such laser was disclosed by Tanetani et al in "32nd Proceeding of Japan Applied Physics Conference", p. 149, No. la-ZB-10 (April, 1985). However, with this structure it is more difficult to cause the fundamental mode to oscillate than higher order modes. Therefore, oscillation occurs in the higher order modes and the radiation beam has two or more components.

Since the oscillation modes of phased-array semiconductor lasers are generally referred to as "supermodes", this specification will hereinafter use the same term.

There now follows an outline description of the supermode but a detailed description can be found in E. Kapon et al., "OPTICS LETTERS", Vol. 10, No. 4, p. 125 (April, 1984).

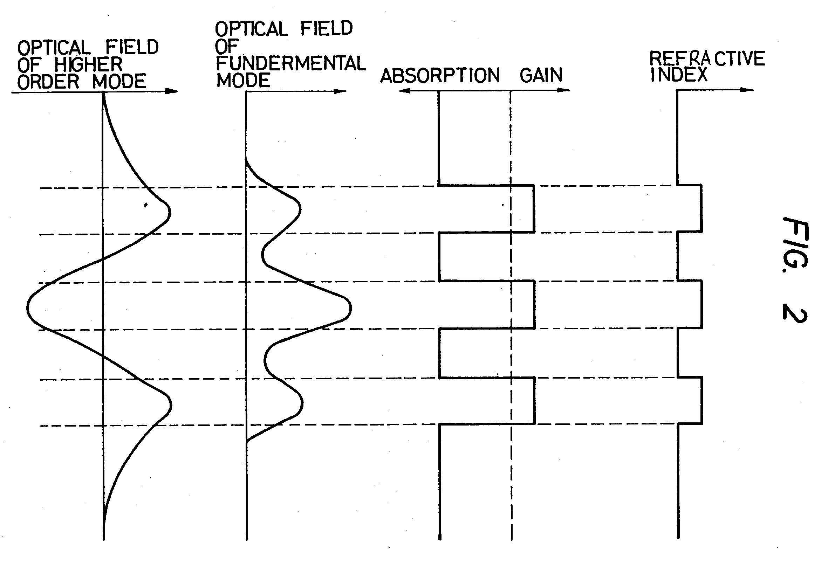

Fig. 2 of the accompanying drawings shows schematically the relationship between the refractive index and gain (absorption) in a phased-array semiconductor laser. Optical gain occurs in regions having a large refractive index, such as an emission stripe region, and large optical absorption occurs in regions having a small refractive index, such as in the gaps between the emission stripe regions. A fundamental mode beam having an optical field such as shown in Fig. 2 has its optical field in a region having large absorption, and since this fundamental mode is absorbed in the gap between the stripe regions, the fundamental mode beam as a whole has a large optical loss and hence, is difficult to generate. In other words, its threshold current is great. On the other hand, a higher order mode beam such as shown in Fig. 2 is more likely to be generated because it has substantially no optical field in regions in which absorption is large and no absorption of the optical field occurs in the regions in which it lies.

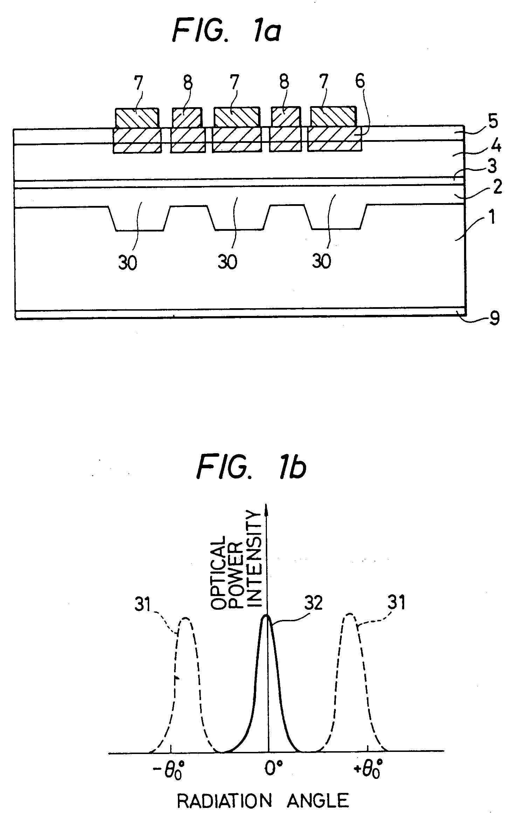

As can also be seen from Fig. 2, the phase of the optical fields of adjacent higher order mode beam differ from each other by 180° and emission beams having a radiation angle near 0° cancel each other out, so that the emission beam has a radiation angle ϑₒ (see Fig. 1(b) of the accompanying drawings. This radiation angle ϑₒ is given by the following formula:

${\text{ϑ}}_{\text{o}} \text{≈ Sin⁻¹ (λ/2S)}$

where S in the gap between the stripe regions and λ is the wavelength of the emission beam.

The known techniques described above do not take into consideration any arrangement which makes the radiation angle of the laser beam changeable and the prior art semiconductor lasers are only designated for high output semiconductor lasers. Most of the known devices have electrodes which do not have separate parts from one another, but are continuous over the entire surface.

However, in IEEE Communications Magazine, Vol. 21, 1983, pages 25-26 there is disclosed a laser diode having an electrode split into parallel stripes and different amounts of currents passed through each stripe, whereby an asymmetric gain profile across the laser active region is established which influences the laser radiation mode and causes beam deflection.

The present invention seeks to provide a laser device in which the direction of laser emission is changeable, due e.g. to switching between the fundamental supermode and a higher order supermode.

Thus, the present invention provides in its first aspect a semiconductor laser device comprising:
a semiconductor substrate;
a resonator formed on said substrate including an active layer, a plurality of stripe regions for emitting an emission beam and a gap region between the stripe regions;
a first electrode on said substrate opposite the resonator; and
a plurality of electrodes on the resonator; wherein the stripe regions are optically coupled and are arranged such that the physical structure of the resonator has a periodic distribution of refractive index; and the plurality of electrodes includes:
a second electrode associated with the stripe regions for controlling the injection of a first current into the stripe regions; and
a third electrode separated from the second electrode for controlling the injection of a second current into the gap regions between the stripe regions;
whereby the radiation angle of the emission beam is changeable by the control of the injection of the first and second currents.

The present invention also provides in its second aspect, a semiconductor laser device comprising:
a semiconductor substrate;
a resonator formed on said substrate including an active layer, a plurality of stripe regions for emitting an emission beam and a gap region between the stripe regions;
a first electrode on said substrate opposite the resonator; and
a plurality of second electrodes on the resonator; wherein
the stripe regions are optically coupled and are arranged such that the physical structure of the resonator has a periodic distribution of refractive index; and
the plurality of second electrodes associated with the stripe regions for controlling the injection of current into the stripe regions, includes at least one electrode which has a gap therein defining separated electrode parts so that first and second currents may be injected independently thereby;
whereby the radiation angle of the emission beam is changeable by the control of the injection of the first and second currents.

The present invention also provides, in its third aspect a semiconductor laser device comprising:
a semiconductor substrate;
a resonator formed on said substrate including an active layer, a plurality of stripe regions for emitting an emission beam and a gap region between the stripe regions;
a first electrode on said substrate opposite the resonator; and
a plurality of electrodes on the resonator; wherein the stripe regions are optically coupled and are arranged such that the physical structure of the resonator has a periodic distribution of refractive index; and
the plurality of electrodes includes a second and a third electrode, the second electrode being associated with the stripe regions for controlling the injection of current into the stripe regions, the third electrode being in contact with at least one region not being within the part of the device containing the stripe regions, the third electrode being for applying voltage signals independent of signals to the second electrode, thereby to change the oscillation mode of the resonator and hence to change the radiation angle of the emission beam.

The provision of a device in which the radiation angle is changeable permits optical switching and optical scanning, which have been difficult to achieve using prior art techniques.

A first stripe region/electrode pattern type which permits the angle of the laser emission to be changed has separate electrodes at the emission stripe regions and at the gaps between the stripe region in a phased-array semiconductor laser.

With such an arrangement, when oscillation is generated by applying a voltage to the electrodes associated with the stripe regions, the highest order mode is generated. Since the phases of the optical field between the stripe regions in the highest order mode are opposite to one another, the emission beam has a distribution having radiation angles at +ϑₒ and -ϑₒ (degrees).

When oscillation is generated by applying a voltage to the electrodes between the stripe regions, the mode generated is the fundamental mode and the emission beam has a distribution in which the radiation angle is substantially zero (0).

Accordingly, the radiation angle of the emission beam may be changed by applying the voltage either to the electrodes associated with the stripe regions or to the other electrodes.

This switching speed is essentially determined by the relaxation oscillation frequency of the semiconductor laser, and about 10 GHz may be expected.

A second stripe region/electrode pattern type which permits the angle of laser emission to be changed has at least one stripe electrode which has gaps therein to form a separate electrode part. When a current is applied to all parts of the electrodes, oscillation occurs in the highest order mode and a beam is emitted in the direction ϑₒ described above. On the other hand, when a current is applied only to the electrodes, and not the separate electrode parts, oscillation occurs in the fundamental mode and the beam is emitted in a direction vertical to a facet of the device.

With this second type of pattern when the current is injected to all the electrodes, the field distribution of all the stripe regions having a high refractive index becomes large and the mode generated is the highest order supermode. When the current is not injected to the separate electrode parts, the emission beam undergoes large absorption at the centre of the stripe regions and the threshold current value of the higher order supermodes becomes large so that oscillation occurs in the fundamental supermode. In the fundamental supermode, the phase of the optical field in each stripe region is the same and the beam is emitted in a direction perpendicular to the laser facet.

A third stripe region/electrode pattern which permits the angle of laser emission to be changed has electrodes outside the stripe regions of the phased-array semiconductor laser so that oscillation occurs in the fundamental supermode when the electric field is applied to the electrodes and in the higher order mode when such an electric field is not applied.

With the third type of pattern, the field distribution of the higher order supermode is due largely to penetration from the stripe regions, and the amount of this penetration is small in the fundamental supermode. Therefore, when the electric field is applied to regions other than the stripe region, the forbidden band width of the active layer becomes great due to the Franz-Kerbisch effect, so that the absorption of the emission beam increases and oscillation is unlikely to occur in the higher order supermodes. As a result, oscillation occurs in the fundamental supermode and when the field is not applied, it occurs in the higher order supermode. For this reason, the radiation angle of the laser beam may be changed in the same way as in the first and second pattern types.

With the first and second pattern types described above, the switching speed between the fundamental supermode and the higher order supermode is essentially determined by the relaxation oscillation frequency of the semiconductor laser and about 10 GHz may be expected. Since switching is made by utilizing absorption with the third pattern type, switching can be made at a higher speed.

When a quantum well structure is used for the active layer of the device a significant change in the forbidden band width may be produced due to the field, and switching can be more effective.

Needless to say, the action of the present invention does not depend upon the number of stripe regions.

The present invention may thus provide a semiconductor laser which permits easy and stable changes in the radiation angle of the emission beams. Such a laser can be applied in practice to a scannable light source for use in data processing terminals such as a laser printer, and to a switchable coupling system of a laser beam in optical communication and optical measurement to an optical fibre and/or an optical waveguide.

Embodiments of the present invention will now be described in detail, by way of example, with reference to the accompanying drawings, in which:
Figs. 1a and 1b are diagrams for explaining a first embodiment of the present invention;
Fig. 2 is a diagram for explaining a supermode, and has already been discussed;
Figs. 3 and 4 are diagrams for explaining second and third embodiments of the present invention respectively;
Fig. 5 shows diagrams for explaining a fourth embodiment of the present invention;
Figs. 6a, 7a and 8a are top views of a device according to the fourth, fifth, and sixth embodiments of the invention;
Figs. 6b, 7b and 8b are cross-sectional views taken along line A - A' of Figs. 6a, 7a and 8a, respectively;
Figs. 6c, 7c and 8c are sectional views taken along line B - B' of Figs. 6a, 7a and 8a, respectively, and corresponding diagrams of refractive indexes;
Fig. 9 is a cross-sectional view of a seventh embodiment of the present invention; and
Fig. 10 is a cross-sectional view of an eighth embodiment of the present invention.

### First Group of Embodiments

In the first three embodiments of the present invention now to be described, the injection of current into the laser device is controlled by a first group of electrodes which inject current into the stripe regions of the laser, and a second group of electrodes which inject current into the gaps between the stripe regions.

### Embodiment 1

Fig. 1a is a cross-sectional view of a laser device in which the present invention is applied to a GaAℓAs system semiconductor laser. Fig. 1b shows the distribution of an emission beam.

Three grooves, each of which is 3 µm wide and 1 µm deep, are formed by photoetching on an n-GaAs substrate 1. At this time, the spacing between the stripe centres is 5 µm. Then, an n-Ga_{0.5}Aℓ_{0.5}As cladding layer 2, an undoped Ga_{0.86}Aℓ_{0.14}As active layer 3, a p-Ga_{0.5}Aℓ_{0.5}As cladding layer 4, and n-GaAs layer 5 are sequentially formed by liquid phase growth. Thereafter, Zn is diffused into the device in stripes to fabricate a diffusion region 6 which reaches the cladding layer 4. The width of the diffusion region over the groove is less than the groove width by 1 µm and the width of the diffusion region over the gap between the grooves is less than the width of the gap between the grooves by 0.5 µm. Thereafter, p-electrodes 7,8 are formed by a lift-off method and, after an n-electrode 9 is formed continuously on the exposed surface of the substrate 1, a laser device having a resonator which is about 300 µm long is obtained by cleaving. When the thickness of the n-Ga_{0.5}Aℓ_{0.5}As cladding layer over the gap between the grooves is between 0.1 and 0.5 µm, the distribution of the refractive indices is as shown in Fig. 2.

The laser device thus fabricated oscillates continuously at a current of 100 to 150 mA and a wavelength of 780 nm at room temperature and the oscillation spectrum exhibits a longitudinal single mode. Fig. 1b shows the far-field pattern (the distribution of the emission beam in a direction parallel to a coupling surface). Dash line 31 in Fig. 1b represents the far-field pattern when a current is injected only to the groove region of the high refractive index region through the electrodes 7. Two emission beams can be observed at radiation angles of +4.5° and -4.5° and the full width at half power (FWHM) is 1.5°. This indicates that a supermode of the highest order has been selected. Solid line 32 in Fig. 1b represents the far-field pattern when a current is injected only to the regions between the grooves of low refractive index through the electrodes 8.
An emission beam having one full width at half power is observed at ±0° and this indicates that the fundamental supermode has been selected. Thus, this structure permits the fundamental supermode and the highest order supermode to be selected independently by suitable current injection. Selection of these supermodes can be made up to an optical output of 300 mW.

### Embodiment 2

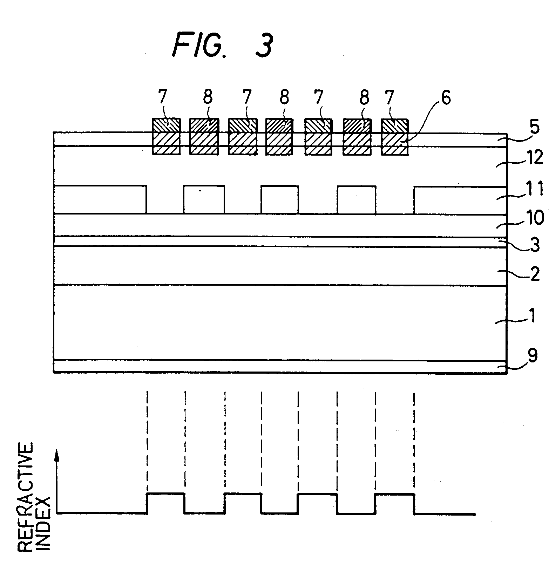

Fig. 3 is a cross-sectional view of a laser in accordance with a second embodiment of the present invention, the figure also showing the refractive index distribution.

An n-Ga_{0.5}Aℓ_{0.5}As cladding layer 2, an undoped Ga_{0.86}Aℓ_{0.14}As active layer, a p-Ga_{0.55}Aℓ_{0.45}As cladding layer 10 and a p-Ga_{0.45}Aℓ_{0.55}As layer 11 are sequentially formed on an n-GaAs substrate 1 by metal organic chemical vapour deposition (MOCVD). The Ga_{0.45}Aℓ_{0.55}As layer 11 is removed completely by photoetching to form four groove stripes which are 3 µm wide and expose the surface of the p-Ga_{0.55}Aℓ_{0.45}As cladding layer 10. In this instance, the spacing between the centres of the stripes is 6 µm, so that the gap between the stripes is 3 µm. A p-Ga_{0.55}Aℓ_{0.45}As buried layer 12 and an n-GaAs layer 5 are then formed by MOCVD. Zn is then diffused onto the device in stripes to form a diffusion layer 6 reaching the p-Ga_{0.55}Aℓ_{0.45}As layer 12. The width of the diffusion region is 1 µm smaller than the width of the diffusion region over the groove and the width over the gap between the grooves.

Next, p-electrodes 7,8 are formed by a lift-off method on each diffusion stripe region only and after an n-electrode 9 is formed, a laser device having a resonator which is about 300 µm long is obtained by cleaving. When the p-Ga_{0.55}Aℓ_{0.45}As cladding layer 10 is 0.05 to 0.6 µm thick at this time, a refractive index distribution such as shown in Fig. 3 may be obtained.

The device thus fabricated may generate continuous oscillation at room temperature, a threshold current of from 100 to 160 mA and a wavelength of 780 nm. When current is injected only to the p-electrode 7 so as to generate gain only in the groove stripes having a high refractive index, a far-field pattern with two emission beams (whose full width at half power is 1.5°) is at +4.0° and -4.0° is observed. It can thus be confirmed that a supermode of the highest order causes this laser oscillation. When current is injected only to the p-electrode 8 and gain is generated only in the groove gap region having a low refractive index, a far-field pattern with one emission beam at ±0° is observed, and thus oscillation at the fundamental supermode can be obtained. In other words, both modes can be selected in a satisfactory manner in the same way as in Embodiment 1 and radiation output of the emission beam of up to 200 mW can be made changeable.

### Embodiment 3

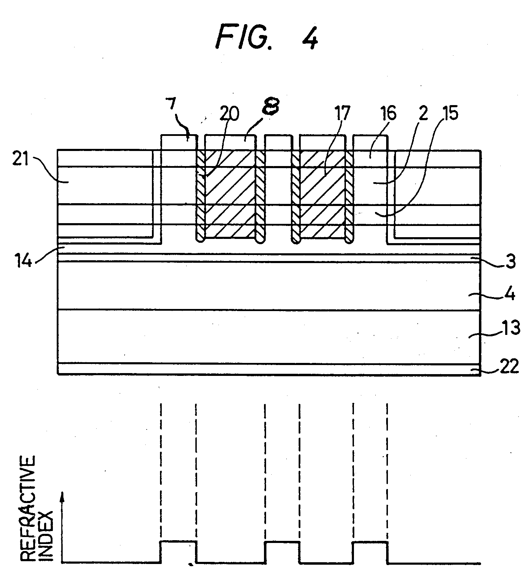

Fig. 4 is a sectional view showing a third embodiment of the present invention, the figure also showing its refractive index distribution.

A p-Ga_{0.5}Aℓ_{0.5}As cladding layer 4, an undoped Ga_{0.86}Aℓ_{0.14}As active layer 3, an n-Ga_{0.55}Aℓ_{0.45}As optical guide layer 14, a superlattice layer 15 formed by alternately laminating 30 layers of 5 nm thick undoped Ga_{0.9}Aℓ_{0.1} well layers and 10 nm thick undoped Ga_{0.3}Aℓ_{0.7}As barrier layers, an Ga_{0.5}Aℓ_{0.5}As cladding layer 2 and an n-GaAs cap layer 16 are sequentially formed by MOCVD. Thereafter, Si ions are injected into the 3 µm wide stripe regions 17 and the outer region of the phased array region such that they extend to the n-Ga_{0.55}Aℓ_{0.45}As optical guide layer 14, thereby forming three stripes. The spacing between the centres of the stripes is 7 µm. Thereafter, n-stripe electrodes 7,8 having 1 µm gaps therebetween are formed by a lift-off method. Then, H+ (proton) ions are injected using the stripe-like n-electrodes 7,8 as a mask to form insulation regions 20 between each electrode at edges of the stripe regions. After a p-electrode 22 is formed, a laser device having a resonator which is about 300 µm long is obtained by cleaving.

In this embodiment, the refractive index of the superlattice layer inside the Si ion injection region gets disordered and causes mixing. The refractive index of the disordered superlattice layer is smaller than that of the superlattice layer which is not disordered. As a result, when the n-Ga_{0.55}Aℓ_{0.45}As optical guide layer 14 is more than 0.5 µm thick, a refractive index distribution such as shown in Fig. 4 can be formed.

The laser device thus fabricated exhibits the same effects as the devices of Embodiments 1 and 2, with the fundamental supermode and the highest order supermode selectable independently by causing a current to flow selectively through the n-electrodes 7 and 8.

In each of the foregoing embodiments of the present invention, substantially the same effect can be obtained when the number of stripes is from 2 to 20, the stripe width is form 1 to 10 µm wide and the stripe spacing is from 1 to 8 µm wide in any combination, thereby to form the stripe structure. A BH (buried hetero) structure, a rib type structure, or similar known structures can be used arbitrarily as an alternative to the structure described above. As an alternative to injection of Zn as described above, it is also possible to use Si or S as the diffusion impurity for insulating the adjacent stripe-like electrodes from one another, and Ga, Aℓ, F and B provide substantially the same effect as the injection ions.

The embodiment can be applied to the beam having a wavelength of from 0.68 to 0.89 µm.

When the same method as in Embodiments 1 through 3 is carried, but with the GaAℓAs system semiconductor replaced by an InGaAsP system semiconductor in Embodiments 1 through 3, the radiation angle can be made changeable for an emission beam having an emission beam wavelength of from 1.3 to 1.5 µm. When the same method as in Embodiments 1 through 3 is carried out, but with the GaAℓAs system semiconductor in Embodiments 1 through 3 replaced by an InGaP system semiconductor, the radiation angle can be made changeable for an emission beam having an emission beam wavelength of from 0.58 to 0.7 µm.

### Second Group of Embodiments

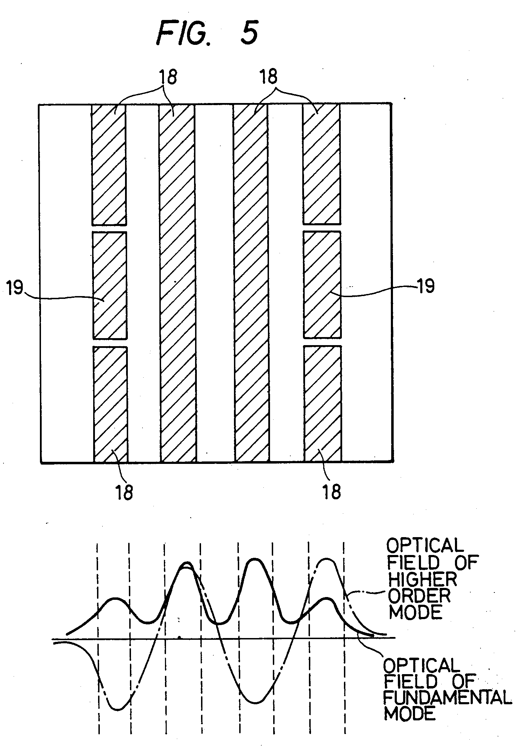

In the next three embodiments of the present invention now to be described, at least some of the stripe regions, and the corresponding electrodes are divided into parts, with gaps therebetween, to form electrode parts 18 and 19 as shown in Fig. 5. When a current is applied to all the electrode parts 18 and 19 then oscillation occurs in the highest order mode, and a beam is emitted in a direction ϑₒ. When current is applied only to the electrode parts 18 in Fig. 5, and not to the electrode parts 19, oscillation occurs in the fundamental mode.

### Embodiment 4

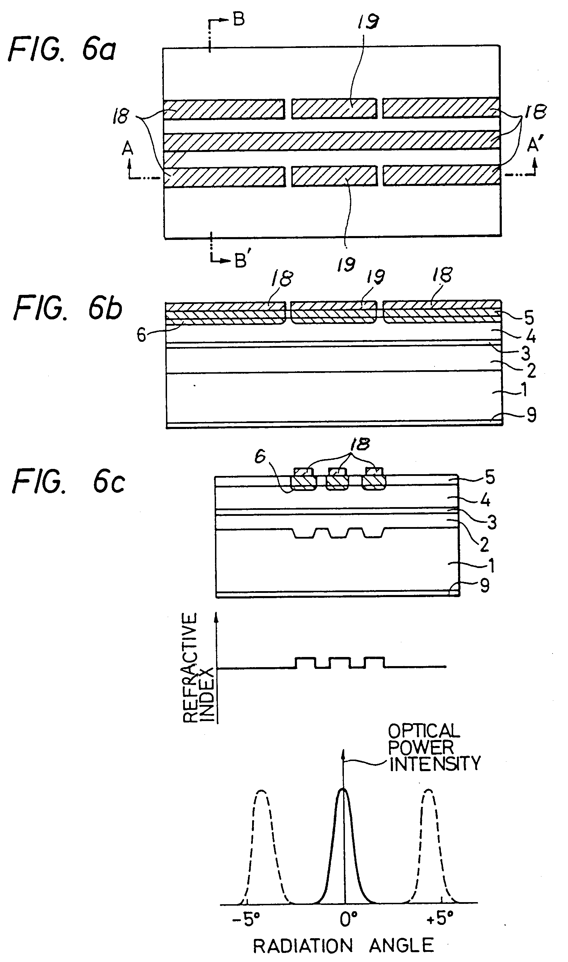

Fig. 6a is a top view of a fourth embodiment of the present invention, showing a GaAℓAs system semiconductor laser, Fig. 6b is a cross-sectional view taken along line A - A' in Fig. 6a and Fig. 6c is a cross-sectional view taken along line B - B' in Fig. 6a, the figure also showing a diagram of the refractive index distribution on the B - B' section and the far-field pattern of the emission beam.

Three grooves which are 3 µm wide and 1 µm deep are formed on an n-GaAs substrate 1 by photoetching. The spacing between the centres of the stripes is 5 µm so that the width of the groove gap is 2 µm. Next, an n-Ga_{0.5}Aℓ_{0.5}As cladding layer 2, an undoped Ga_{0.86}Aℓ_{0.14}As active layer 3, a p-Ga_{0.5}Aℓ_{0.5}As cladding layer 4 and an n-GaAs layer 5 are sequentially formed by liquid phase growth. Zn is then diffused in stripes to form a diffusion region 6 which reaches the p-Ga_{0.5}Aℓ_{0.5}As cladding layer 4. The width of the diffusion region over the groove is less than the groove width by 1 µm and the width of the diffusion region over the gap between the grooves is less than the width of the groove gap by 0.5 µm. Thereafter, p-electrodes 18,19 are formed only in each stripe region with diffusion by the lift-off method, and after an n-electrode 9 is formed, a laser device having a resonator length of about 300 µm can be obtained by cleaving. The electrode 19, that is, the length of an independent current injection electrode part, is 50 µm. The Zn diffused stripes and the stripe-like electrode thereon causes insulation between the adjacent electrodes. When the n-Ga_{0.5}Aℓ_{0.5}As cladding layer is from 0.1 to 0.5 µm thick over the gap between the grooves, a refractive index distribution such as shown in Fig. 6 can be obtained.

The device thus fabricated generates continuous oscillation at room temperature, a threshold current of from 100 to 150 mA and a wavelength of 780 nm, and its oscillation spectrum exhibits a single longitudinal mode. Fig. 6c shows its far-field pattern (in a direction parallel to the joint surface). The far-field pattern when a current is injected to the p-electrodes 18 and 19 in order to inject the current to all the stripe regions is represented by a dash line in the figure. Two emission beams are observed at +4.5° and -4.5° and the full width at half power is 1.5°. This indicates that the highest order mode has been selected. On the other hand, the far-field pattern when a current is injected only to the p-electrode 18 is represented by solid line in the drawing. One emission beam having a full width at half power of 1.5° is observed at ±0° and this indicates that the fundamental mode has been selected. Thus, the fundamental supermode and the highest order supermode can be selected by current injection. The selection of both supermodes can be made to an optical output of 300 mW.

### Embodiment 5

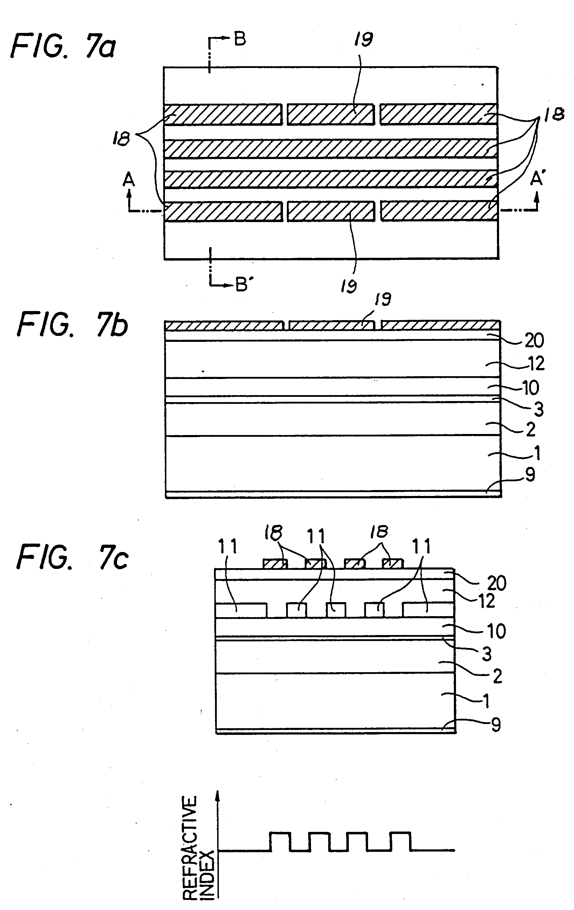

Figs. 7a to 7c show a fifth embodiment of the present invention. Fig. 7a is a top view of a laser Fig. 7b is a cross-sectional view taken along line A - A' in Fig. 7a and Fig. 7c is a cross-sectional view taken along line B - B' in Fig. 7a, the figure also including a diagram showing the refractive index distribution.

An n-Ga_{0.5}Aℓ_{0.5}As cladding layer 2, an undoped Ga_{0.86}-Aℓ_{0.14}As active layer 3, a p-Ga_{0.55}Aℓ_{0.45}As cladding layer 10 and an n-Ga_{0.45}Aℓ_{0.55}As layer 11 are sequentially formed on an n-GaAs substrate 1 by MOCVD. After the n-Ga_{0.45}-Aℓ_{0.55}As layer 11 is removed completely by photoetching, four groove stripes which are 3 µm wide and expose the surface of the p-Ga_{0.55}Aℓ_{0.45}As cladding layer 10 are formed. At this time, the spacing between the stripe centres is 6 µm or in other words, the stripe gap is 3 µm. Thereafter, a buried layer 12 of p-Ga_{0.55}Aℓ_{0.45}As and a p-GaAs layer 20 are formed by MOCVD. Then, p-electrodes 18,19 are formed by a lift-off method and after an n-electrode 9 is formed, a laser device having a resonator which is about 300 µm long is obtained by cleaving. The length of the electrode 19, the independent current injection electrode is 100 µm. When the p-Ga_{0.55}Aℓ_{0.45}As cladding layer 10 is from 0.05 to 0.6 µm thick in this instance, a refractive index distribution is obtained such as shown in Fig. 7c.

The device thus fabricated generates continuous oscillation at room temperature, a threshold current of 100 to 160 mA and a wavelength of 780 nm. Current is injected to the p-electrodes 18,19 in order to inject the current to all the stripe regions. The resultant far-field pattern exhibits two emission beams (with the full width at half power of 1.5° for each beam) at +4.0° and -4.0°, and thus the highest order supermode is selected. On the other hand, when a current is injected only to the p-electrode 18, the far-field pattern has one emission beam at ±0° and the fundamental supermode is obtained. In other words, either mode can be selected in a satisfactory manner in the same way as in Embodiment 1 and the radiation angle of the emission beam can be made changeable to an optical output of up to 200 mW.

### Embodiment 6

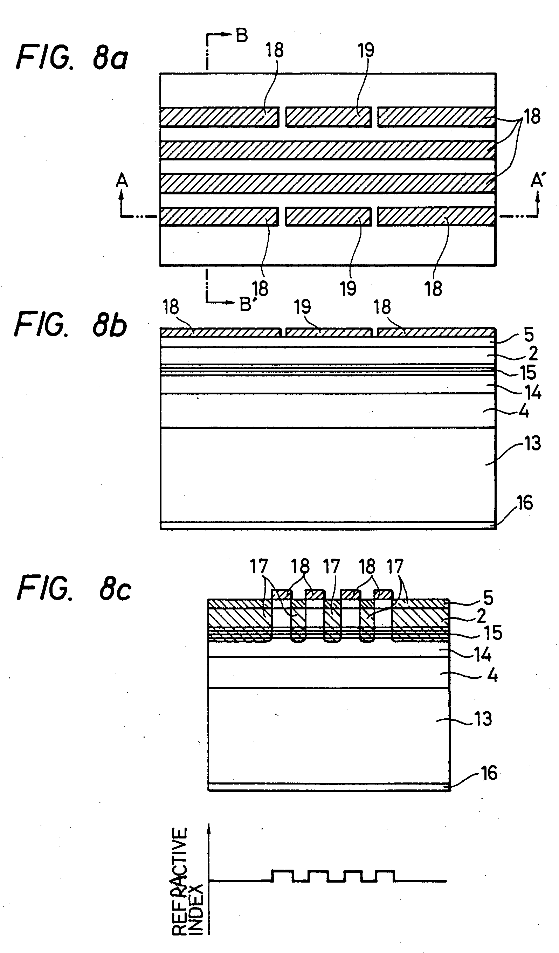

Figs. 8a to 8c show a sixth embodiment of the present invention. Fig. 8a is a top view of a laser, Fig. 8b is a cross-sectional view taken along line A - A' in Fig. 8a and Fig. 8c is a cross-sectional view taken along line B - B' in Fig. 8a, the figure also showing a diagram of the refractive index distribution of the active layer of the laser device.

A p-Ga_{0.5}Aℓ_{0.5}As cladding layer 4, a p-Ga_{0.55}Aℓ_{0.45}As optical guide layer 14, a superlattice active layer 15 formed by alternately laminating five each 100 Å (1Å = 10⁻¹⁰m) thick undoped Ga_{0.9}Aℓ_{0.1}As well layers and 50 Å thick undoped Ga_{0.7}Aℓ_{0.3}As barrier layers, an n-Ga_{0.5}Aℓ_{0.5}As cladding layer 2 and an n-GaAs cap layer 5 are sequentially formed on a p-GaAs substrate 13 by MOCVD. Then, Si ions are injected 17 into 3 µm wide stripe regions 17 and the outer region 17 of the phased-array region so as to reach the p-Ga_{0.55}Aℓ_{0.45}As optical guide layer 14, thereby forming four stripe regions. The spacing between the stripe regions is 7 µm. Thereafter, n-side stripe electrodes 18, 19 are formed by a lift-off method and, after a p-electrode 16 is formed, a laser device having a resonator which is about 300 µm long is obtained by cleaving.

The length of the electrode 19, the independent current injection electrode, is 100 µm. In this embodiment, the refractive index of the superlattice layer inside the Si ion injection region becomes disordered and mixed. The refractive index of this disordered superlattice layer is smaller than that of the superlattice layer which is not disordered. As a result, when the n-Ga_{0.55}Aℓ_{0.45}As optical guide layer 14 is up to 0.5 µm thick, a refractive index distribution such as shown in Fig. 8c is obtained.

The device thus fabricated provides similar effects to those of Embodiments 4 and 5. In other words, when current is injected to the n-electrodes 18,19, thus injecting current to all the stripe regions, the highest order supermode is selected and when the current is injected only to the n-electrode 18, the fundamental supermode is selected.

Incidentally, in Embodiments 4 to 6 of the present invention, the number of stripes is preferably between 2 and 20.

### Third Group of Embodiments

In the third group of embodiments of the present invention, now to be described, the injection of current into the device occurs into parts of the device other than the parts containing the stripe regions, and in particular current is injected by one or more electrodes on one or both sides of the part of the device containing the stripe regions.

### Embodiment 7

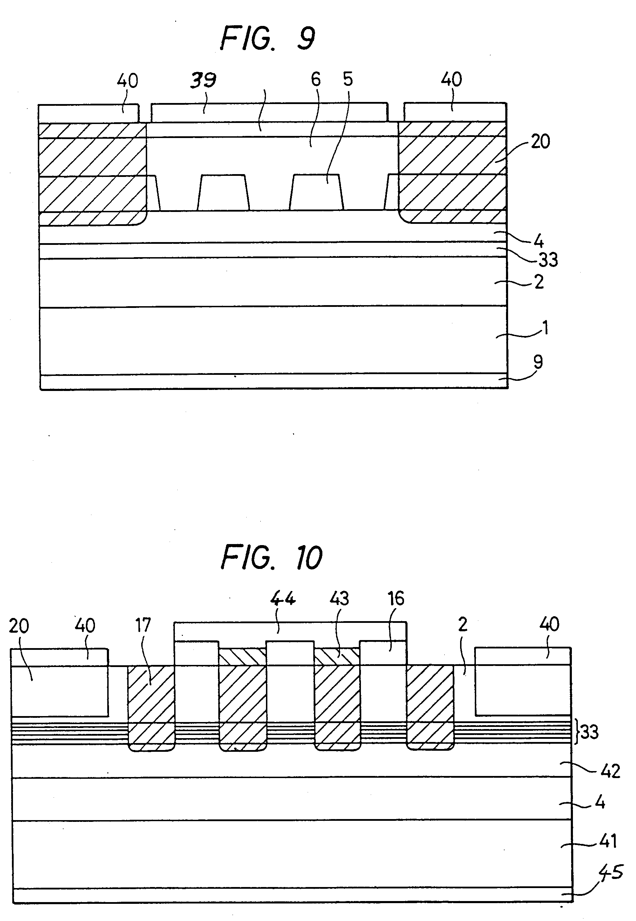

Fig. 9 is a sectional view of a laser device of a seventh embodiment in which the present invention is applied to a GaAℓAs system semiconductor laser.

An n-Ga_{0.5}Aℓ_{0.5}As cladding layer 2, a multi-quantum well active layer 33 formed by alternately laminating six each of 8 nm thick Ga_{0.9}Aℓ_{0.10}As well layers and 4nm thick Ga_{0.70}Aℓ_{0.30}As barrier layers, a p-Ga_{0.5}Aℓ_{0.5}As cladding layer 4 and an n-GaAs current blocking layer 5 are sequentially formed on an n-GaAs substrate crystal 1 by MOCVD.
The n-GaAs layer 5 is removed completely by photoetching and three groove stripes are formed which are 4 µm wide and expose the surface of the p-Ga_{0.5}Aℓ_{0.5}As cladding layer. At this time, the spacing between the stripe centres is 6 µm.

Thereafter, proton (H+) ions are injected to regions outside the phased-array region to form a proton injection region 20. The proton ions are injected so that they extend to the n-GaAs current blocking layer 5 or the p-Ga_{0.5}Aℓ_{0.5}As cladding layer 6. The region into which the protons are injected becomes an insulating layer and no current injection occurs into this region. Then a p-electrode 39 and an electrode 40 for applying an electric field are formed on the phased-array region and on the proton injection region 20, respectively, and thus a laser device having a resonator which is about 300 µm long can be obtained. The p-Ga_{0.5}Aℓ_{0.5}As cladding layer 4 is between 0.1 and 0.5 µm thick and the laser is thus of a refractive index type. There can thus be obtained a high output phased-array laser having low aberration.

The device thus fabricated generates continuous oscillation at room temperature, a threshold current of from 100 to 120 mA and a wavelength of 780 nm, and its oscillation spectrum exhibits a single longitudinal mode. When the voltage of the electrode 40 is zero, two emission beams (each having a full width at half power of 1.5°) are observed at +4.0° and -4.0° in the far-field pattern and thus the highest order supermode has been selected. On the other hand, when the voltage of the electrode 40 is +5V, one emission beam (full width at half power of 1.5°) is observed at ±0° in the far-field pattern and the fundamental supermode oscillation is selected.

The fundamental mode is selected because the effective forbidden band width of the multi-quantum well layer 33 is small due to the application of the field and the loss of the laser beam becomes great. When a voltage +3 V is applied to the field application electrode 40, two emission beams having the full width at half power of 1.5° are observed at +1.5° and -1.5° and this mode is the secondary supermode. Thus, all the three kinds of supermodes can be selected freely by changing the voltage to be applied to the electrode 40.

### Embodiment 8

An eigth embodiment of the present invention will now be described with reference to Fig. 10, which shows a cross-sectional view of a laser device.

A p-Ga_{0.5}Aℓ_{0.5}As cladding layer 4, a p-Ga_{0.6}Aℓ_{0.4}As optical guide layer 42, a multi-quantum well active layer 33 formed by alternately laminating five 70 Å thick Ga_{0.92}Aℓ_{0.08}As well layers and five 40 Å thick Ga_{0.72}Aℓ_{0.28}As barrier layers, an n-Ga_{0.5}Aℓ_{0.5}As cladding layer 2 and an n-GaAs cap layer are sequentially formed on a p-GaAs substrate 41 by MOCVD. By photoetching the n-GaAs cap layer three n-GaAs 5 µm wide stripes 16 are produced, and Si ions are injected into the rest of regions so as to reach the active layer 33 and to form a layer 17 which is disordered and mixed Here, the spacing-between the centres of the stripes is 8 µm. An SiO₂ film 43 is deposited onto the gaps between the n-GaAs stripes 16, and a p-electrode 44 and an n-electrode 45 are formed. Thereafter, proton ions are injected into the outer parts of the phased-array region to form a proton injection region, and a field application electrode 40 is formed thereon. A laser device having a resonator which is about 300 µm long is then obtained by cleaving. The laser device thus fabricated exhibits the similar effects to that of Embodiment 7, and the fundamental supermode and the highest order supermode can be selected independently by applying a voltage to the electrode 40. Further, it is preferable that at least one layer of quantum well layers has a thickness less than a De Broglie wavelength of the electron, or that the active layer consists of only one layer having a thickness less than a De Broglie wavelength of the electron.

The stripe structure of each of the Embodiments of the present invention may have any combination of the stripe regions of from 2 to 20 and a stripe gap width of from 1 to 8 µm. A BH structure, a rib-type structure, and similar structures can be used to form the fundamental stripe structure of the present invention as alternatives to the stripe structure described above.

In addition to the generation of wavelengths of around 0.78 µm, as discussed in each of the above embodiments, similar effects can be obtained throughout all the ranges using a GaAℓAs system semiconductor laser to generate a wavelength of 0.68 to 0.89 µm with continuous oscillation at room temperature. A semiconductor laser device in accordance with the present invention can be applied in the same way to laser materials other than the GaAℓAs system such as an InGaAsP system or an InGaP system. As an alternative to a laser structure based on a three-layer slab structure shown in each of the embodiments, the present invention can also be applied to an LOC structure where an optical guide layer is adjacent one side of the active layer, a separate confinement heterostructure (SCH) where the optical layers are adjacent both sides of the active layer and a graded index separate confinement heterostructure (GRIN-SCH) where the refractive index and forbidden band width of the optical guide layers are distributed in the direction of the thickness of the film.

In each of the embodiments, the same effect can be obtained when the conduction types are reversed (such as p to n and n to p).

In each of the embodiments of the present invention, the same effect can be obtained by a combination of from 2 to 20 stripes, a stripe region width of from 1 to 10 µm and the stripe gap width of from 1 to 8 µm. As alternatives Zn, Si and S may be used as the diffusion impurity for isolation of electrodes of the adjacent stripe electrodes, and Ga, Aℓ, F and B can provide substantially the same effect.

It will be obvious for those skilled in the art that the present invention can be applied to the structure of semiconductor lasers within the entire range which may oscillate continuously at room temperature.

## Claims

1. A semiconductor laser device comprising:
a semiconductor substrate (1,13);
a resonator formed on said substrate including an active layer (3), a plurality of stripe regions (30) for emitting an emission beam and a gap region between the stripe regions;
a first electrode (9,22) on said substrate opposite the resonator; and
a plurality of electrodes (7,8) on the resonator;
wherein:
the stripe regions (30) are optically coupled and are arranged such that the physical structure of the resonator has a periodic distribution of refractive index; and
the plurality of electrodes includes:
a second electrode (7) associated with the stripe regions for controlling the injection of a first current into the stripe regions; and
a third electrode (8) separated from the second electrode (7) for controlling the injection of a second current into the gap regions between the stripe regions;
whereby the radiation angle of the emission beam is changeable by the control of the injection of the first and second currents.

2. A semiconductor laser device comprising:
a semiconductor substrate (1,13);
a resonator formed on said substrate including an active layer (3,15), a plurality of stripe regions for emitting an emission beam and a gap region between the stripe regions;
a first electrode (9,16) on said substrate opposite the resonator; and
a plurality of second electrodes (18,19) on the resonator;
wherein:
the stripe regions are optically coupled and are arranged such that the physical structure of the resonator has a periodic distribution of refractive index; and
the plurality of second electrodes associated with the stripe regions for controlling the injection of current into the stripe regions, includes at least one electrode (18) which has a gap therein defining separated electrode parts (19) so that first and second currents may be injected independently thereby;
whereby the radiation angle of the emission beam is changeable by the control of the injection of the first and second currents.

3. A semiconductor laser device comprising:
a semiconductor substrate (1,41);
a resonator formed on said substrate including an active layer (33), a plurality of stripe regions for emitting an emission beam and a gap region between the stripe regions;
a first electrode (9,45) on said substrate opposite the resonator; and
a plurality of electrodes (39,40,44) on the resonator; wherein:
the stripe regions are optically coupled and are arranged such that the physical structure of the resonator has a periodic distribution of refractive index; and
the plurality of electrodes includes a second and a third electrode, the second electrode (39,44) being associated with the stripe regions for controlling the injection of current into the stripe regions, the third electrode (40) being in contact with at least one region (20) not being within the part of the device containing the stripe regions, the third electrode (40) being for applying voltage signals independent of signals to the second electrode, thereby to change the oscillation mode of the resonator and hence to change the radiation angle of the emission beam.

4. A device according to claim 3, wherein the electrical signals applied to the third electrode (40) are electric field signals.

5. A device according to claim 4, wherein the resonator further includes proton injection regions (20); the third electrode (40) is on the proton injection regions, and the electrical signals are voltage signals applied to the third electrode on the proton injection region.

6. A device according to claim 5, wherein the resonator further comprises a current blocking layer (5) having the stripe regions therein; the active layer (33) is located between cladding layers (2,4) which are located between the substrate (1) and the current blocking layer (5); and the proton injection regions (20) extend to a depth less than the active layer (33).

7. A device according to claim 6, wherein the resonator further comprises an optical guide layer (42) located between the cladding layer which is on the side of the substrate (41), and the active layer (33); the stripe regions extend to a depth less than the active layer (33); and the second electrode (44) is in preselected stripe regions.

8. A device according to any one of claims 5 to 7 wherein the active layer (33) is a multi-quantum well active layer.

9. A device according to any one of claims 5 to 8 wherein the third electrode (40) has insulating regions thereunder.

10. A device according to claim 9, wherein the insulating regions correspond to the proton-injection regions.

11. A device according to any one of claims 1 and 2, wherein the resonator further includes a cladding layer (2) located between said substrate (1) and said active layer (3), a plurality of semiconductor layers including a further cladding layer (4) on said active layer, and a plurality of diffused regions (6) in said plurality of semiconductor layers, to a depth less than said active layer (3), having said plurality of electrodes (7,8) thereon.

12. A device according to claim 11, wherein said active layer (3) and said cladding layers (2,4) are located between said substrate (1) and a semiconductor layer (11); and said stripe regions are in said semiconductor layer (11).

13. A device according to claim 12 wherein the resonator further includes a plurality of semiconductor layers and a plurality of diffused regions (6) are in said plurality of layers, to a depth less than said active layer (3), corresponding to said stripe regions and the gap therebetween, and said plurality of electrodes (7,8) are formed on said diffused regions.

14. A device according to any one of claims 1 and 2, wherein the resonator further comprises an optical guide layer (14) and a superlattice active layer (15), both said layers being located between cladding layers (2,4), and said optical guide layer (14) being located between the cladding layer (4) which is on the side of the substrate (13), and said superlattice active layer (15).

## Patentansprüche

1. Halbleiterlaser-Bauelement mit:
- einem Halbleitersubstrat (1, 13);
- einem auf dem Substrat ausgebildeten Resonator mit einer aktiven Schicht (3), mehreren streifenförmigen Bereichen (30) zum Emittieren eines Emissionsstrahls und einem Lückenbereich zwischen den streifenförmigen Bereichen;
- einer ersten Elektrode (9, 22) auf dem Substrat, dem Resonator gegenüberliegend; und
- mehreren Elektroden (7, 8) auf dem Resonator;
wobei
- die streifenförmigen Bereiche (30) optisch gekoppelt sind und so angeordnet sind, daß die physische Struktur des Resonators eine periodische Verteilung des Brechungsindexes aufweist; und
- die mehreren Elektroden folgende beinhalten:
- eine zweite Elektrode (7), die den streifenförmigen Bereichen zugeordnet ist, um die Injektion eines ersten Stroms in die streifenförmigen Bereiche zu steuern; und
- eine dritte Elektrode (8), die von der zweiten Elektrode (7) getrennt ist, um die Injektion eines zweiten Stroms in die Lückenbereiche zwischen den streifenförmigen Bereichen zu steuern;
-- wobei der Abstrahlwinkel des Emissionsstrahls durch die Steuerung der Injektion des erste und zweiten Stroms veränderbar ist.

2. Halbleiterlaser-Bauelement mit:
- einem Halbleitersubstrat (1, 13);
- einem auf dem Substrat ausgebildeten Resonator mit einer aktiven Schicht (3, 15), mehreren streifenförmigen Bereichen zum Emittieren eines Emissionsstrahls und einem Lückenbereich zwischen den streifenförmigen Bereichen;
- einer ersten Elektrode (9, 16) auf dem Substrat, dem Resonator gegenüberliegend; und
- mehreren zweiten Elektroden (18, 19) auf dem Resonator;
wobei
- die streifenförmigen Bereiche optisch gekoppelt sind und so angeordnet sind, daß die physische Struktur des Resonators eine periodische Verteilung des Brechungsindexes aufweist; und
- die mehreren zweiten Elektroden , die den streifenförmigen Bereichen zum Steuern der Injektion von Strom in die streifenförmigen Bereiche zugeordnet sind, mindestens eine Elektrode aufweisen, die eine Lücke aufweist, um getrennte Elektrodenteile (19) festzulegen, so daß dadurch ein erster und ein zweiter Strom unabhängig voneinander injiziert werden können;
- wobei der Abstrahlwinkel des Emissionsstrahls durch die Steuerung der Injektion des erste und zweiten Stroms veränderbar ist.

3. Halbleiterlaser-Bauelement mit:
- einem Halbleitersubstrat (1, 41);
- einem auf dem Substrat ausgebildeten Resonator mit einer aktiven Schicht (33), mehreren streifenförmigen Bereichen zum Emittieren eines Emissionsstrahls und einem Lückenbereich zwischen den streifenförmigen Bereichen;
- einer ersten Elektrode (9, 45) auf dem Substrat, dem Resonator gegenüberliegend; und
- mehreren Elektroden (39, 40, 44) auf dem Resonator;
wobei
- die streifenförmigen Bereiche optisch gekoppelt sind und so angeordnet sind, daß die physische Struktur des Resonators eine periodische Verteilung des Brechungsindexes aufweist; und
- die mehreren Elektroden eine zweite und eine dritte Elektrode aufweisen, wobei die zweite Elektrode (39, 44) den streifenförmigen Bereichen zugeordnet ist, um die Injektion von Strom in die streifenförmigen Bereiche zu steuern; und die dritte Elektrode (40) in Berührung mit mindestens einem Bereich (20) steht, der nicht innerhalb desjenigen Teils des Bauelementes liegt, der die streifenförmigen Bereiche enthält, wobei die dritte Elektrode (40) vorhanden ist, um Spannungssignale unabhängig von Signalen an die zweite Elektrode anzulegen, um dadurch die Schwingungsmode des Resonators zu ändern und dadurch den Abstrahlwinkel des Emissionsstrahls zu ändern.

4. Bauelement nach Anspruch 3, bei dem die an die dritte Elektrode (40) gelegten Signale elektrische Feldsignale sind.

5. Bauelement nach Anspruch 4, bei dem der Resonator ferner Protoneninjektionsbereiche (20) aufweist; die dritte Elektrode (40) auf den Protoneninjektionsbereichen liegt, und die elektrischen Signale Spannungssignale sind, die an die dritte Elektrode auf dem Protoneninjektionsbereich gelegt werden.

6. Bauelement nach Anspruch 5, bei dem der Resonator ferner eine Stromsperrschicht (5) aufweist, die die streifenförmigen Bereiche enthält; die aktive Schicht (33) zwischen Mantelschichten (2, 4) angeordnet ist, die zwischen dem Substrat (1) und der Stromsperrschicht (5) liegen; und sich die Protoneninjektionsbereiche (20) bis in eine geringere Tiefe als die aktive Schicht (33) erstrecken.

7. Bauelement nach Anspruch 6, bei dem der Resonator ferner eine optische Leiterschicht (42) aufweist, die zwischen der Mantelschicht auf der Seite des Substrats (41) und der aktiven Schicht (33) liegt; die streifenförmigen Bereiche sich bis in eine Tiefe geringer als die der aktiven Schicht (33) erstrecken, und die zweite Elektrode (44) in vorausgewählten streifenförmigen Bereichen liegt.

8. Bauelement nach einem der Ansprüche 5 bis 7, bei dem die aktive Schicht (33) eine aktive Schicht mit Mehrfachquantentrog ist.

9. Bauelement nach einem der Ansprüche 5 bis 8, bei dem die dritte Elektrode (40) unter sich Isolierbereiche aufweist.

10. Bauelement nach Anspruch 9, bei dem die Isolierbereiche den Protoneninjektionsbereichen entsprechen.

11. Bauelement nach einem der Ansprüche 1 oder 2, bei dem der Resonator ferner eine zwischen dem Substrat (1) und der aktiven Schicht (3) liegende Mantelschicht (2), mehrere Halbleiterschichten einschließlich einerweiteren Mantelschicht (4) auf der aktiven Schicht sowie mehrere eindiffundierte Bereiche (6) in den mehreren Halbleiterschichten bis in eine Tiefe geringer als diejenige der aktiven Schicht (3) aufweist, mit mehreren Elektroden (7, 8) darauf.

12. Bauelement nach Anspruch 11, bei dem die aktive Schicht (3) und die Mantelschichten (2, 4) zwischen dem Substrat (1) und einer Halbleiterschicht (11) liegen; und die streifenförmigen Bereiche in der Halbleiterschicht (11) liegen.

13. Bauelement nach Anspruch 12, bei dem der Resonator ferner mehrere Halbleiterschichten aufweist und mehrere eindiffundierte Bereiche (6) in den mehreren Schichten mit einer Tiefe geringer als die aktive Schicht (3) liegen, entsprechend den streifenförmigen Bereichen und der Lücke dazwischen, und wobei die mehreren Elektroden (7, 8) auf den eindiffundierten Bereichen ausgebildet sind.

14. Bauelement nach einem der Ansprüche 1 oder 2, bei dem der Resonator ferner eine optische Leiterschicht (14) und eine aktive Übergitterschicht (15) aufweist, wobei diese beiden Schichten zwischen den Mantelschichten (2, 4) liegen, und wobei die optische Leiterschicht (14) zwischen der Mantelschicht (4) auf der Seite des Substrats (13) und der aktiven Übergitterschicht (15) liegt.

## Revendications

1. Dispositif laser à semiconducteurs comprenant :
un substrat semiconducteur (1,13);
un résonateur formé sur ledit substrat et comprenant une couche active (3), une pluralité de régions en forme de bandes (30) servant à émettre un faisceau d'émission et une zone d'intervalle entre les régions en forme de bandes;
une première électrode (9,22) située sur ledit substrat à l'opposé du résonateur; et
une pluralité d'électrodes (7,8) situées sur le résonateur;
dans lequel
les régions en forme de bandes (30) sont couplées optiquement et sont agencées de telle sorte que la structure physique du résonateur possède un indice de réfraction à distribution périodique; et
la pluralité des électrodes comprend :
une seconde électrode (7) associée aux régions en forme de bandes pour commander l'injection d'un premier courant dans les régions en forme de bandes; et
une troisième électrode (8) séparée de la seconde électrode (7) pour commander l'injection d'un second courant dans les zones d'intervalle entre les régions en forme de bandes;
l'angle de rayonnement du faisceau d'émission pouvant être modifié par la commande de l'injection des premier et second courants.

2. Dispositif laser à semiconducteurs comprenant :
un substrat semiconducteur (1,13);
un résonateur formé sur ledit substrat et comprenant une couche active (3,15), une pluralité de régions en forme de bandes servant à émettre un faisceau d'émission et une zone d'intervalle entre les régions en forme de bandes;
une première électrode (9,16) située sur ledit substrat à l'opposé du résonateur; et
une pluralité de secondes électrodes (18,19) situées sur le résonateur;
dans lequel
les régions en forme de bandes sont couplées optiquement et agencées de telle sorte que la structure physique du résonateur possède un indice de réfraction à distribution périodique; et
la pluralité de secondes électrodes associées aux régions en forme de bandes pour la commande de l'injection de courant dans les régions en forme de bandes comprend au moins une électrode (18), qui contient un intervalle définissant des parties séparées (19) de l'électrode, de sorte que les premier et second courants peuvent de ce fait être injectés d'une manière indépendante;
l'angle de rayonnement du faisceau d'émission pouvant être modifié au moyen de la commande de l'injection des premier et second courants.

3. Dispositif laser à semiconducteurs comprenant :
un substrat semiconducteur (1,41);
un résonateur formé sur ledit substrat et comprenant une couche active (33), une pluralité de régions en forme de bandes pour l'émission d'un faisceau d'émission et une zone d'intervalle entre les régions en forme de bande;
une première électrode (9,45) située sur ledit substrat à l'opposé du résonateur; et
une pluralité d'électrodes (39,40,44) situées sur le résonateur;
dans lequel :
les régions en forme de bandes sont couplées optiquement et disposées de telle sorte que la structure physique du résonateur possède un indice de réfraction à distribution périodique;
la pluralité d'électrodes comprend des seconde et troisième électrodes, la seconde électrode (39,44) étant associée aux régions en forme de bandes servant à commander l'injection du courant dans les régions en forme de bandes, la troisième électrode (40) étant en contact avec au moins une région (20) qui n'est pas située à l'intérieur de la partie du dispositif contenant les régions en forme de bandes, la troisième électrode (40) servant à appliquer des signaux de tension indépendants de signaux envoyés à la seconde électrode, de manière à modifier le mode d'oscillation du résonateur et par conséquent modifier l'angle de rayonnement du faisceau d'émission.

4. Dispositif selon la revendication 3, dans lequel les signaux électriques appliqués à la troisième électrode (40) sont des signaux de champ électrique.

5. Dispositif selon la revendication 4, dans lequel le résonateur comprend des régions (20) d'injection de protons, la troisième électrode (40) est située sur les régions d'injection de protons, et les signaux électriques sont des signaux de tension qui sont appliqués à la troisième électrode sur la zone d'injection de protons.

6. Dispositif selon la revendication 5, dans lequel le résonateur comprend en outre une couche (5) de blocage du courant contenant les régions en forme de bandes; la couche active (33) est située entre des couches de revêtement (2,4) qui sont situées entre le substrat (1) et la couche (5) de blocage du courant; et les régions d'injection de protons (20) s'étendent à une profondeur inférieure à celle de la couche active (33).

7. Dispositif selon la revendication 6, dans lequel le résonateur comprend en outre une couche formant guide optique (42), située entre la couche de revêtement, qui est située sur le côté du substrat (41), et la couche active (33); les régions en forme de bandes s'étendant à une profondeur inférieure à celle de la couche active (33); et la seconde électrode (44) se situe dans des régions en forme de bandes présélectionnées.

8. Dispositif selon l'une quelconque des revendications 5 à 7, dans lequel la couche active (33) est une couche active à puits quantiques multiples.

9. Dispositif selon l'une quelconque des revendications 5 à 8, dans lequel des régions isolantes sont disposées au-dessous de la troisième électrode (40).

10. Dispositif selon la revendication 9, dans lequel les régions isolantes correspondent aux régions d'injection de protons.

11. Dispositif selon l'une quelconque des revendications 1 et 2, dans lequel le résonateur comporte en outre une couche de revêtement (2) située entre ledit substrat (1) et ladite couche active (3), une pluralité de couches semiconductrices comprenant une autre couche de revêtement (4) située sur ladite couche active, et une pluralité de régions diffusées (6) dans ladite pluralité de couches semiconductrices, à une profondeur inférieure a celle de ladite couche active (3), lesdites régions diffusées portant une pluralité d'électrodes (7,8).

12. Dispositif selon la revendication 11, dans lequel ladite couche active (3) et lesdites couches de revêtement (2,4) sont situées entre ledit substrat (1) et une couche semiconductrice (11); et lesdites régions en forme de bandes sont situées dans ladite couche semiconductrice (11).

13. Dispositif selon la revendication 12, dans lequel le résonateur comprend en outre une pluralité de couches semiconductrices, et une pluralité de régions diffusées (6) sont situées dans ladite pluralité de couches, à une profondeur inférieure à celle de ladite couche active (3), d'une manière qui correspond auxdites régions en forme de bandes et à l'intervalle entre ces régions, et ladite pluralité d'électrodes (7,8) est formée sur lesdites régions diffusées.

14. Dispositif selon l'une quelconque des revendications 1 et 2, dans lequel le résonateur comprend en outre une couche formant guide optique et une couche active formant super-réseau (15), lesdites couches étant toutes deux situées entre les couches de revêtement (2,4), et ladite couche formant guide optique (14) étant située entre la couche de revêtement (4) qui est située sur le côté du substrat (13), et ladite couche active de superréseau (15).
